(19) Europäisches Patentamt
European Patent Office
Office européen des brevets

(11) EP 2 593 805 B1

(12) FASCICULE DE BREVET EUROPEEN

(45) Date de publication et mention
de la délivrance du brevet:
**11.01.2017 Bulletin 2017/02**

(51) Int Cl.:
*G01R 33/38* (2006.01)    *G01R 33/3815* (2006.01)
*G01R 33/3873* (2006.01)    *H01F 6/06* (2006.01)
*G01R 33/3875* (2006.01)

(21) Numéro de dépôt: **11741648.7**

(22) Date de dépôt: **08.07.2011**

(86) Numéro de dépôt international:
**PCT/FR2011/051634**

(87) Numéro de publication internationale:
**WO 2012/007680 (19.01.2012 Gazette 2012/03)**

(54) **DISPOSITIF D'AIMANT SUPRACONDUCTEUR**

**SUPRALEITENDE MAGNETVORRICHTUNG**

**SUPERCONDUCTING MAGNET DEVICE**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.07.2010 FR 1055818**

(43) Date de publication de la demande:
**22.05.2013 Bulletin 2013/21**

(73) Titulaire: **Commissariat à l'Énergie Atomique et aux Énergies Alternatives
75015 Paris (FR)**

(72) Inventeur: **AUBERT, Guy
F-86000 Poitiers (FR)**

(74) Mandataire: **Desormiere, Pierre-Louis et al
Cabinet Beau de Loménie
158, rue de l'Université
75340 Paris Cedex 07 (FR)**

(56) Documents cités:
**US-A- 4 584 548    US-A- 6 084 497
US-A1- 2009 261 246**

**Description**

Domaine de l'invention

La présente invention a pour objet un dispositif d'aimant supraconducteur capable de produire un champ magnétique intense et homogène Bz selon un axe Oz dans une zone d'intérêt ZI pouvant présenter un volume important comme par exemple pour des applications de résonance magnétique nucléaire (RMN) ou d'imagerie par résonance magnétique (IRM).

L'invention concerne également un procédé de réalisation d'un tel dispositif d'aimant supraconducteur.

Art antérieur

La réalisation d'aimants produisant un champ magnétique très homogène dans un volume important, notamment pour la RMN ou l'IRM, conduit à utiliser des configurations magnétiques spécifiques dont la mise en oeuvre peut s'avérer très délicate. D'où l'idée de rechercher une structure d'aimant simple et facile à réaliser avec précision, comme par exemple un bobinage en couches hélicoïdales suffisamment long pour que les transitions d'une couche à la suivante et les jonctions inévitables entre longueurs successives de conducteurs soient situées assez loin du volume d'intérêt pour ne pas perturber l'homogénéité théorique calculable du bobinage hélicoïdal.

Un bobinage hélicoïdal n'est pas axisymétrique mais le pas de l'hélice est en général suffisamment petit pour que les écarts qui en résultent par rapport à un bobinage théorique axisymétrique soient négligeables. Par ailleurs, il est possible de choisir le nombre de tours par couche et le nombre de couches pour que l'on ait une compensation quasi parfaite de ces écarts. On se limitera donc pour la suite à des configurations purement axisymétriques d'axe Oz également symétriques par rapport à leur plan médian $xOy$. Le développement en harmoniques sphériques (DHS) de la composante $B_z$ du champ dans la zone d'intérêt intérieure (« trou » de l'aimant) prend alors la forme très simple suivante :

$$B_z = Z_0 + \sum_{p=1}^{\infty} Z_{2p} r^{2p} P_{2p}(\cos \vartheta)$$

Ce DHS est valable à l'intérieur de la plus grande sphère de centre $O$ et ne contenant aucun courant ou matériau aimanté.

On montre facilement que les coefficients relatifs $\dfrac{Z_n}{Z_0}$ de ce DHS sont des fonctions décroissantes du rayon minimum $a_1$ du bobinage comme $\dfrac{1}{a_1^n}$. Ainsi, pour réaliser une homogénéité théorique donnée dans une sphère centrée à l'origine de rayon $a < a_1$, il faudra annuler tous les $Z_{2p}$ pour $1 \leq p \leq p_0$. On cherche bien entendu à le faire de la façon la plus économique possible.

Pour des raisons évidentes (installation, utilisation, perturbations extérieures...) on cherche à limiter le champ extérieur généré par l'aimant (« champ de fuite »). La méthode théorique est similaire à celle utilisée pour l'homogénéité mais on utilise le DHS dit extérieur valable à l'extérieur de la plus petite sphère de centre $O$ et ne contenant aucun courant ou matériau aimanté :

$$B_z = \sum_{p=1}^{\infty} M_{2q} \frac{1}{r^{2q+1}} P_{2q}(\cos \vartheta)$$

Les coefficients de ce DHS sont appelés « moments » de la distribution de courant et le premier d'entre eux, $M_2$, est le moment dipolaire.

La première disposition à prendre pour réduire le champ extérieur consiste à annuler le moment dipolaire, ce qui implique la mise en oeuvre de courants tournant autour de $Oz$ en sens inverse de ceux qui produisent le champ dans le volume d'intérêt, ce qui contribue donc à le réduire.

On a déjà proposé, par exemple dans le document US 2009/0261246 A1, une configuration d'aimant supraconducteur comprenant une bobine supraconductrice principale de longueur $L_1$ présentant une symétrie de rotation autour d'un axe z pour créer dans un espace interne un champ magnétique principal et une bobine supraconductrice auxiliaire extérieure coaxiale à la bobine supraconductrice principale, de longueur $L_2$ inférieure à la longueur $L_1$, et présentant une symétrie de rotation autour de l'axe z pour créer dans l'espace interne un champ de direction opposée à celle du champ créé par la bobine supraconductrice principale. La configuration d'aimant supraconducteur comprend en outre des anneaux en matériau ferromagnétique qui sont disposés dans le volume intérieur défini par la bobine supraconductrice principale afin de permettre des compensations et accroître l'homogénéité du champ magnétique dans le volume d'intérêt.

Un tel dispositif permet ainsi d'améliorer l'homogénéité du champ magnétique dans le volume d'intérêt, au prix d'un accroissement du poids dû aux anneaux en matériau ferromagnétique, mais surtout d'une restriction de l'espace libre dans le volume d'intérêt, puisque les anneaux en matériau ferromagnétique sont disposés à l'intérieur de l'espace libre défini par la bobine supraconductrice principale. Si l'on veut conserver le même espace libre pour le volume d'intérêt, on est ainsi conduit à accroître les dimensions hors tout de l'ensemble du dispositif en augmentant le diamètre des bobines supraconductrices, ce qui nuit à la compacité et augmente le coût de réalisation.

Définition et objet de l'invention

La présente invention vise à remédier aux inconvénients précités et à permettre la réalisation d'un dispositif d'aimant supraconducteur plus compact que les dispositifs existants tout en étant facile à réaliser et qui permette d'obtenir dans un volume d'intérêt un champ magnétique intense et très homogène capable d'être utilisé notamment pour des applications de RMN ou IRM.

Par champ magnétique intense, on entend un champ magnétique au moins égal à 0,5T, de préférence supérieur ou égal à 1T, et qui dans certaines réalisations, peut dépasser 10T.

L'invention vise encore à définir un procédé de réalisation d'un tel dispositif qui soit simplifié et permette néanmoins une optimisation de l'homogénéisation du champ magnétique créé dans le volume d'intérêt.

Ces buts sont atteints, conformément à l'invention, grâce à un dispositif d'aimant supraconducteur compact pour générer une composante de champ magnétique homogène Bz selon un axe Oz dans une zone d'intérêt ZI pour des applications de résonance magnétique nucléaire ou d'imagerie par résonance magnétique, tel que défini par la revendication 1.

Le dispositif d'aimant supraconducteur selon l'invention peut être mis en oeuvre quelle que soit la valeur de champ souhaitée. Il peut en particulier être utilisé pour l'obtention d'une composante de champ magnétique homogène Bz intense par exemple égale à 10 ou 11 teslas.

L'invention concerne également un procédé de réalisation d'un dispositif d'aimant supraconducteur pour générer une composante de champ magnétique homogène Bz selon un axe Oz dans une zone d'intérêt ZI pour des applications de résonance magnétique nucléaire ou d'imagerie par résonance magnétique, tel que défini par la revendication 8.

Brève description des dessins

D'autres caractéristiques et avantages de l'invention ressortiront de la description suivante de modes particuliers de réalisation de l'invention donnés à titre d'exemples en référence aux dessins annexés, sur lesquels :

- La Figure 1 représente une vue schématique d'un dispositif d'aimant avec deux solénoïdes à demi-section axiale rectangulaire d'épaisseur significative et anneaux intermédiaires en matériau magnétique, selon un premier mode de réalisation de l'invention, et
- La Figure 2 représente une vue schématique d'un dispositif d'aimant avec trois solénoïdes à demi-section axiale rectangulaire d'épaisseur significative et anneaux intermédiaires en matériau magnétique, selon un deuxième mode de réalisation de l'invention.

Description détaillée de modes de réalisation préférentiels

Selon l'invention, le procédé d'optimisation de structures d'aimants constituées de bobinages axisymétriques à demi-section axiale rectangulaire comprend une première étape consistant à ne pas prendre en compte l'épaisseur des bobinages. En effet il a été constaté que la prise en compte *ab initio* de l'épaisseur des bobinages alourdit les calculs et ne permet pas d'appréhender facilement les caractéristiques essentielles de la structure.

Selon l'invention, on considère donc, lors d'une première étape, des configurations à base de nappes de courant superficielles portées par des cylindres circulaires d'axe *Oz*. Dans la suite de la description, une telle nappe de courant sera appelée « solénoïde mince » sans autre précision.

Chaque solénoïde mince est caractérisé par son rayon $a$, les cotes $b_1$ et $b_2$ de ses première et deuxième extrémités permettant de définir une longueur $2b$ ou une demi-longueur $b$, ainsi que par la densité superficielle de courant azimutale $\kappa$ qu'il porte, mesurée algébriquement autour de $Oz$. On utilisera les notations suivantes :

$$c = \sqrt{a^2 + b^2}$$

$$\sin\alpha = \frac{a}{c}$$

$$\cos\alpha = \frac{b}{c}$$

Les coefficients des développements en harmoniques sphériques (DHS) intérieur et extérieur s'obtiennent par les expressions suivantes :

$$Z_0 = \frac{\mu_0 \kappa}{2} \big[\cos\alpha\big]_{b_1}^{b_2}$$

$$Z_{n\geq 1} = -\frac{\mu_0 \kappa}{2n}\left[\frac{1}{c^n}\sin\alpha\, P_n^1(\cos\alpha)\right]_{b_1}^{b_2}$$

$$M_{n\geq 2} = \frac{\mu_0 \kappa}{2(n+1)}\left[c^{n+1}\sin\alpha\, P_n^1(\cos\alpha)\right]_{b_1}^{b_2}$$

On rappelle que $M_0 = 0$ car les équations de Maxwell ont été écrites de façon à faire disparaître les charges magnétiques en ne laissant subsister que les charges électriques (pas de « monopôle » magnétique). Par ailleurs, l'expression de $M_n$ ci-dessus conduit à $M_1 = 0$ et le premier moment non nul *a priori* est le moment dipolaire, propriété générale pour toute distribution de courant.

Ces expressions révèlent une propriété remarquable. Si l'on considère un ensemble de tels solénoïdes coaxiaux dont les cercles d'extrémités se situent sur une même sphère de rayon $c$, chaque solénoïde n'est plus caractérisé que par deux paramètres $\alpha_i$ et $\kappa_i$. Cette configuration peut être qualifiée de « circumsphérique ». Pour réaliser un aimant homogène, on choisit ces paramètres pour annuler simultanément les $Z_{2n}$ (les termes de degré impair sont nuls par raison de symétrie par rapport à $xOy$) jusqu'à un degré $2n_0$, les moments $M_{2n}$ seront également tous annulés jusqu'au même degré. En améliorant l'homogénéité, on diminue donc ici concomitamment le champ extérieur.

La mise en oeuvre de deux solénoïdes permet d'annuler $Z_2$ et donc simultanément $M_2$. Selon l'invention, on met en oeuvre des configurations à deux ou trois solénoïdes qui permettent d'améliorer l'homogénéité tout en contribuant à parfaire l'homogénéité du champ en ajoutant des anneaux de fer, ou plus généralement des anneaux en matériau magnétique, dans un espace libre compris entre le bobinage hélicoïdal supraconducteur principal le plus interne délimitant le volume de la zone d'intérêt et le bobinage hélicoïdal supraconducteur coaxial au bobinage hélicoïdal supraconducteur principal qui entoure immédiatement celui-ci, tout en laissant entièrement libre la zone d'intérêt ZI située à l'intérieur du bobinage hélicoïdal supraconducteur principal le plus interne.

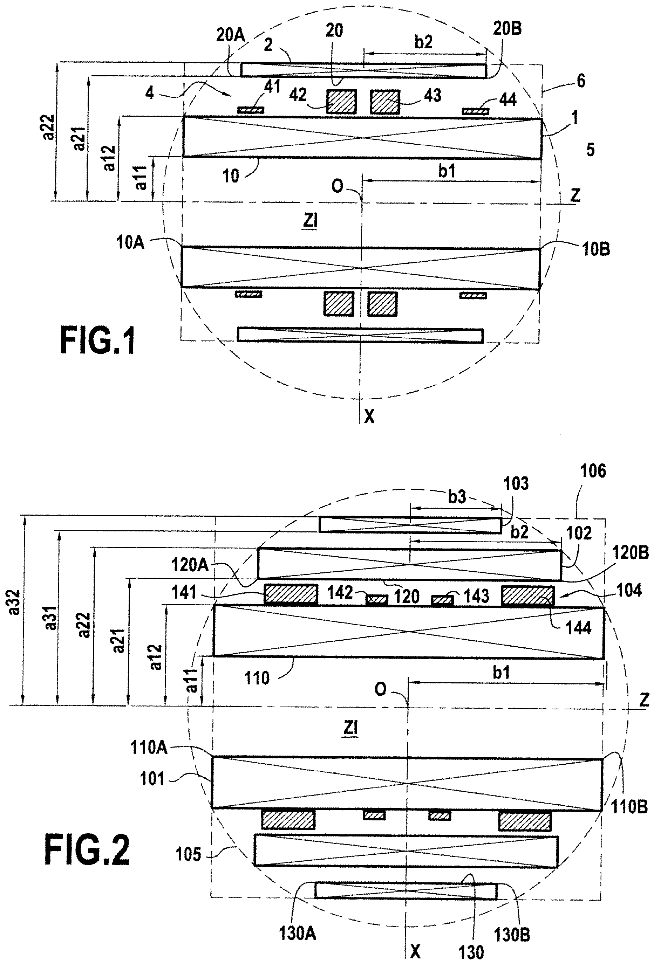

La Figure 1 montre un aimant circumsphérique selon l'invention dans sa configuration à deux solénoïdes 1, 2 disposés de façon coaxiale autour de l'axe Oz en allant de l'intérieur vers l'extérieur, tandis que la Figure 2 montre un aimant circumsphérique selon l'invention dans sa configuration à trois solénoïdes 101, 102, 103 disposés de façon coaxiale autour de l'axe Oz en allant de l'intérieur vers l'extérieur, des anneaux de matériau magnétique aimantés à saturation 4 (Figure 1) ou 104 (Figure 2) étant insérés entre le premier solénoïde 1 respectivement 101 et le deuxième solénoïde 2 respectivement 102 mais la zone d'intérêt ZI définie par le tronc de cylindre 10 respectivement 110 sur lequel est réalisé le premier solénoïde 1 respectivement 101 restant entièrement dégagée et exempte de tels anneaux de matériau magnétique.

Les anneaux 4, 104 en matériau magnétique permettent d'améliorer l'homogénéité d'un aimant. Ces anneaux permettent de réaliser un aimant homogène avec deux bobinages seulement 1, 2 mais, dans les réalisations de l'art antérieur, ils ont l'inconvénient d'occuper une partie de la place libre dans le volume d'intérêt et donc de conduire à une augmentation du rayon intérieur de bobinage si l'on veut conserver le même accès libre.

Dans les configurations selon l'invention, on prend en compte le fait que, dans une réalisation à au moins deux bobinages supraconducteurs coaxiaux 1, 2 respectivement 101, 102 présentant des densités de courant azimutales orientées en sens inverse, il existe un espace libre entre le bobinage intérieur 1, respectivement 101, et le bobinage coaxial suivant 2, respectivement 102, qui constitue une région où le champ est en sens inverse du champ au centre O, est très sensiblement uniforme et encore assez intense pour saturer largement l'aimantation d'un anneau ou d'une série d'anneaux en matériau magnétique 4, 104 qui y sont placés. Comme l'aimantation est alors en sens inverse du champ au centre O, elle contribue à le renforcer et donc à diminuer le volume de supraconducteur nécessaire pour obtenir le même champ que sans anneau 4, 104.

Cette propriété est bien vérifiée dans les exemples représentés sur les Figures 1 et 2 où l'on insère dans cette région quatre anneaux en fer aimantés à saturation 41 à 44 (Figure 1) respectivement 141 à 144 (Figure 2).

Dans le cas de la Figure 2, avec l'exemple qui sera donné plus bas, on peut améliorer l'homogénéité d'un dispositif similaire sans anneau en fer, en diminuant de 7.3 % le volume de supraconducteur nécessaire pour les bobinages 101 à 103, qui devient 18.693 $m^3$, tandis que le volume de fer nécessaire (qui est moins coûteux que le matériau supraconducteur) est de 1.578 $m^3$ et l'espace de la zone d'intérêt ZI reste entièrement libre.

On peut annuler rigoureusement un terme supplémentaire, soit $Z_6$, et le seul terme restant est $Z_8$ = -0.072 *ppm* @ $r_0$ = 0.2 *m.* L'homogénéité est donc tout à fait remarquable avec la ligne 1 *ppm* à z = 0.2805 *m* sur l'axe et $\rho$ = 0.3233 *m* dans le plan médian.

À l'extérieur, la ligne des 5 *gauss* est plus éloignée sur l'axe, soit 9.7 *m*, mais plus proche dans la plan médian, soit 5.418 *m*. On obtient ainsi une amélioration sensible de l'homogénéité, en diminuant de 1.465 $m^3$ le volume de bobinage en matériau supraconducteur coûteux pour le remplacer par un volume de fer sensiblement égal moins coûteux et surtout en préservant l'espace libre dans le volume d'intérêt et en n'augmentant pas les dimensions hors tout de l'ensemble du dispositif.

La Figure 1 concerne plus spécifiquement l'homogénéisation d'un aimant à deux bobines simples 1, 2. Comme dans le cas d'une réalisation à trois bobines, telle que celle de la Figure 2, il est possible de trouver une solution à deux bobines dont l'homogénéité est obtenue au moyen d'anneaux 4 placés dans la région intermédiaire où ils sont aimantés à saturation avec une aimantation en sens inverse du champ au centre O. On obtient ainsi une solution à un nombre réduit de bobines (deux) qui n'encombre pas le diamètre intérieur libre, contrairement à d'autres réalisations de l'art antérieur.

À titre d'exemple, on trouvera ci-après les paramètres d'un aimant permettant de produire un champ magnétique supérieur à 11 teslas tout en étant moins encombrant que les réalisations de l'art antérieur déjà proposées pour obtenir une telle intensité de champ magnétique et qui améliore en outre l'homogénéité.

Les rayons interne et externe des bobinages supraconducteurs sont ici notés $a_1$ et $a_2$ respectivement tandis que la demi-longueur des bobinages supraconducteurs est notée b et les cotes extrêmes des anneaux de fer 42, 43 ou 41, 44 respectivement sont notées $b_1$ et $b_2$ respectivement :

Bobinages supraconducteurs

| $a_1$ (m) | $a_2$ (m) | b(m) | $j(A/mm^2)$ |
|---|---|---|---|
| 0.5 | 0.930625 | 1.9 | 31.6 |
| 1.363319 | 1.5 | 1.281941 | -37.92 |

Anneaux de fer ($\mu_0 M$ = -2.2 *T*)

| $a_1$ (m) | $a_2$ (m) | $b_1$(m) | $b_2$(m) |
|---|---|---|---|
| 0.975 | 1.220573 | 0.075942 | 0.374249 |
| 0.975 | 1.017437 | 1.055777 | 1.315642 |

$$B_0 = 11.7436 \, T$$

$$V_S = 10.507 \, m^3$$

$$V_F = 1.149 \, m^3$$

$$Z_2 = Z_4 = Z_6 = 0$$

$$M_2 = 0$$

Dans cet exemple, on fixe au départ le rayon interne $a_1$ de la bobine 1 (soit 0,5m), la demi-longueur b de cette bobine 1 (soit 1,9m), le rayon externe $a_2$ de la bobine 2 (soit 1,5m), le rayon interne $a_1$ de chaque série d'anneaux 41, 44 et 42, 43 (soit 0,975m), ainsi que les densités de courant azimutales j des bobines 1 et 2 (soit respectivement 31,6 A/mm$^2$ et -37,92 A/mm$^2$) et on détermine par le calcul les autres mesures nécessaires pour définir le dispositif d'aimant (c'est-à-dire le rayon externe $a_2$ de la bobine 1, le rayon interne $a_1$ de la bobine 2, la demi-longueur b de la bobine 2, les rayons externes $a_2$ des anneaux de fer 41, 44 et 42, 43 et les cotes extrêmes $b_1$ et $b_2$ des anneaux de fer 42, 43 ou 41, 44).

Le volume de bobinage est égal à 9.948 $m^3$ et il y a environ 9.04 *tonnes* de fer. Bien que les coefficients du DHS intérieur ne soient annulés rigoureusement que jusqu'à l'ordre 6 inclus, l'homogénéité est excellente car les coefficients suivants sont très petits. Ainsi, pour $r_0 = 0.2 \, m$, les seuls coefficients supérieurs au *ppb* sont :

$$Z_8 = -0.097 \ ppm$$

$$Z_{10} = 0.006 \ ppm$$

La ligne 1 *ppm* se trouve à $z = 0.2714 \, m$ sur l'axe et à $\rho = 0.3092 \, m$ dans le plan médian.

Comme on ne peut annuler que le moment dipolaire, la ligne des *5 gauss* se situe à 10.58 *m* sur l'axe et à 10,36 *m* dans la plan médian, soit un résultat sensiblement meilleur que celui d'autres réalisations ne mettant pas en oeuvre l'invention (12.25 *m* et 9.885 *m* respectivement).

Le matériau d'homogénéisation peut être adapté à la valeur du champ. En effet, les exemples précédents sont relatifs à des aimants qui génèrent des champs magnétiques suffisamment grands pour que l'on puisse utiliser des éléments d'insertion en matériau magnétique ayant une aimantation à saturation au moins aussi élevée que celle du fer, tel que du fer ou un alliage de fer et notamment un alliage de fer et de cobalt.

Si l'on veut réaliser un champ plus faible soit $B_0' = k B_0$, $k < 1$, il suffit, sans rien changer aux dimensions calculées pour du fer, de choisir un matériau doux dont l'aimantation à saturation est $\mu_0 M = K \mu_0 M_{\mathrm{Fe}} \approx K \times 2.2T$. De tels matériaux peuvent être obtenus sans difficultés dans la famille des ferrites de composition $XFe_2O_4$ où $X$ peut être un des éléments *Mn, Zn, Ni, Co, Cu, Mg, Fe...* ou un mélange de ces éléments dans les proportions appropriées.

On peut noter qu'avec $X = Fe$, on a la magnétite $Fe_3O_4$ mais on peut avantageusement utiliser des ferrites douces à base des trois premiers éléments cités, soit *Mn, Zn, Ni.*

Sur les Figures 1 et 2, on voit que l'on peut mettre en oeuvre par exemple deux paires d'anneaux de sections différentes 41, 44 et 42, 43 (Figure 1) ou 141, 144 et 142, 143 (Figure 2) disposés symétriquement par rapport au plan médian xOy perpendiculaire à l'axe Oz. Sur la Figure 1, la paire d'anneaux centrale 42, 43 présente une section plus grande que celle de la paire d'anneaux extérieurs 41, 44, les longueurs des différents anneaux étant semblables. Sur la Figure 2, c'est la paire d'anneaux extérieurs 141, 144 qui présente une section plus grande que celle de la paire d'anneaux centrale 142, 143, les longueurs des anneaux centraux 142, 143 étant plus courtes que celles des anneaux extérieurs 141, 144. Le nombre et la taille relative des différents anneaux peuvent être différents des exemples donnés sur les dessins.

Sur la figure 1, les deux solénoïdes 1, 2 définis chacun par une tranche de cylindre 10, 20 respectivement limitée par des cercles d'extrémité 10A, 10B, 20A, 20B inscrits essentiellement au voisinage d'une plus petite sphère 5 de rayon c, présentent des densités de courant azimutales qui sont de signes opposés. Ainsi, par exemple on a pour le solénoïde 1 une densité de courant azimutale j positive tandis que l'on a pour le solénoïde intermédiaire 2 une densité de courant azimutale j négative.

De façon similaire, sur la figure 2, les trois solénoïdes 101, 102, 103 définis chacun par une tranche de cylindre 110, 120, 130 respectivement limitée par des cercles d'extrémité 110A, 110B, 120A, 120B, 130A, 130B inscrits essentiellement au voisinage d'une plus petite sphère 105 de rayon c, présentent des densités de courant azimutales qui sont de signes opposés. Ainsi, par exemple on a pour les solénoïdes 101 et 103 une densité de courant azimutale j positive tandis que l'on a pour le solénoïde intermédiaire 102 une densité de courant azimutale j négative.

Comme on l'a déjà indiqué plus haut, selon l'invention, on considère d'abord, lors d'une première étape, des configurations à base de nappes de courant superficielles portées par des cylindres circulaires d'axe Oz, de telles nappes de courant étant appelées « solénoïdes minces », pour déterminer les paramètres relatifs à un dispositif d'aimant selon l'invention, puis on prend en compte les épaisseurs réelles des bobines pour finaliser la détermination des caractéristiques de dispositif d'aimant. Il est en effet plus facile de déterminer les caractéristiques principales du dispositif d'aimant aptes à la production d'un champ homogène en considérant des solénoïdes minces, sans faire intervenir les épaisseurs réelles des bobines, puis dans une deuxième étape, d'ajuster les paramètres pour tenir compte de ces épaisseurs réelles.

L'invention concerne ainsi en particulier un procédé de réalisation d'un dispositif d'aimant supraconducteur pour générer une composante de champ magnétique homogène Bz selon un axe Oz dans une zone d'intérêt ZI, qui comprend les étapes suivantes :

a) déterminer une première tranche de cylindre circulaire 10 (Figure 1) ou 110 (Figure 2) d'axe Oz délimitée par des premiers cercles d'extrémité 10A, 10B respectivement 110A, 110B et présentant un premier rayon prédéfini $a_1$ et une première longueur prédéfinie $2b_1$ correspondant respectivement au rayon minimum et à la longueur maximum de la zone d'intérêt ZI,

b) déterminer une dernière tranche de cylindre circulaire 20 respectivement 130 d'axe Oz délimitée par des derniers cercles d'extrémité 20A, 20B respectivement 130A, 130B, entourant la première tranche de cylindre circulaire 10 respectivement 110 et présentant un dernier rayon prédéfini $a_2$ ; $a_3$ et une dernière longueur prédéfinie $2b_2$ ; $2b_3$ de telle sorte que ladite dernière tranche de cylindre circulaire 20 respectivement 130 soit contenue dans une sphère de rayon c et de centre O contenant ladite zone d'intérêt ZI,

c) considérer une première nappe de courant superficielle formée sur la première tranche de cylindre circulaire 10 respectivement 110 d'axe Oz, et une dernière nappe de courant superficielle mince formée sur la dernière tranche de cylindre circulaire 20 respectivement 130 d'axe Oz, les nappes de courant superficielles successives coaxiales présentant chacune une densité superficielle de courant azimutale $\kappa_i$ telle que deux nappes de courant superficielles coaxiales adjacentes présentent des densités superficielles de courant azimutales de signes opposés et déterminer la géométrie d'anneaux 4 respectivement 104 en matériau magnétique intermédiaires centrés sur l'axe Oz et présentant une symétrie par rapport à un plan médian xOy passant par le centre O de la sphère 5 respectivement 105 et perpendiculaire à l'axe Oz et interposés entre les premier et deuxièmes bobinages 1, 2 respectivement 101, 102 à l'intérieur de ladite sphère 5 respectivement 105, lesdits anneaux 4 respectivement 104 étant aimantés avec une aimantation en sens inverse de celle du champ créé au centre O de ladite sphère 5 respectivement 105 de manière à optimiser l'homogénéité du champ magnétique dans ladite zone d'intérêt ZI, et

d) remplacer les nappes de courant superficielles coaxiales successives par des bobinages hélicoïdaux supraconducteurs axisymétriques à demi-section axiale rectangulaire d'épaisseur non nulle 1, 2 respectivement 101, 102, 103 tels que les extrémités latérales des bobinages hélicoïdaux 1, 2 respectivement 101, 102, 103 soient disposées au voisinage d'une même sphère 5 respectivement 105 de rayon c dont le centre O est placé sur l'axe Oz au centre de ladite zone d'intérêt ZI et qui englobe l'ensemble du dispositif d'aimant.

Pour les configurations réelles finales des bobinages hélicoïdaux supraconducteurs à demi-section axiale rectangulaire d'épaisseur non nulle, on a utilisé les notations suivantes sur les Figures 1 et 2 :

Rayon interne des premières bobines 1, 101 : $a_{11}$
Rayon externe des premières bobines 1, 101 : $a_{12}$
Rayon interne des deuxièmes bobines 2, 102 : $a_{21}$
Rayon externe des deuxièmes bobines 2, 102 : $a_{22}$
Rayon interne des troisièmes bobines 103 : $a_{31}$
Rayon externe des troisièmes bobines 103 : $a_{32}$
Longueur des premières bobines 1, 101 : $2b_1$
Longueur des deuxièmes bobines 2, 102 : $2b_2$
Longueur des troisièmes bobines 103 : $2b_3$

Pour les configurations à solénoïdes minces, on considère un seul rayon qui est alors noté comme suit :

Rayon des premiers solénoïdes minces : $a_1$
Rayon des deuxièmes solénoïdes minces : $a_2$
Rayon du troisième solénoïde mince : $a_3$

La configuration circumsphérique à trois solénoïdes de la Figure 2 dépend de 5 paramètres si l'on affecte les indices 1, 2 et 3 respectivement pour chacun des solénoïdes minces:

$$\alpha_1, \alpha_2, \alpha_3$$

$$\frac{\kappa_2}{\kappa_1}, \frac{\kappa_3}{\kappa_1}$$

On peut satisfaire deux (et pas plus !) conditions d'homogénéité :

$$Z_2 = Z_4 = 0$$

qui entraîneront l'annulation du moment dipolaire et du moment quadripolaire.

$\alpha_1$ est fixé *a priori* par le rayon intérieur utile $a_1$ du solénoïde mince qui correspond à une tranche de cylindre circulaire 110 d'axe Oz limitée par des cercles d'extrémité 110A, 110B et délimitant une zone d'intérêt ZI devant être libre et soumise à un champ magnétique le plus homogène possible,
$\alpha_3$ est fixé *a priori* par le rayon extérieur < c à ne pas dépasser pour le solénoïde mince le plus externe.

Il reste alors un degré de liberté et donc une possibilité d'optimisation. La grandeur gouvernant celle-ci est le facteur de qualité dont l'expression générale pour une configuration circumsphérique de solénoïdes minces est la suivante :

$$Q = \frac{\sin^2 \alpha_1 \left| \sum_i \kappa_i \cos \alpha_i \right|}{\sum_i |\kappa_i| \sin \alpha_i \cos \alpha_i}$$

Il suffit de maximiser $Q$ en respectant les contraintes susmentionnées pour déterminer complètement la configuration.

Si à titre d'exemple on impose les valeurs suivantes pour les premier et troisième solénoïdes:

$$\begin{array}{l} a_1 = 1\,m \\ b_1 = 3.7\,m \end{array} \rightarrow \alpha_1 = 0.263964$$

$$\alpha_3 = \frac{\pi}{2} - \alpha_1 \rightarrow \begin{array}{l} a_3 = 3.7\,m \\ b_3 = 1\,m \end{array}$$

On constate que l'on a défini un ensemble « carré » 106 dont la longueur $2b_1$ est égale au diamètre extérieur $2a_3$ du troisième solénoïde.

La solution optimale est alors déduite pour le deuxième solénoïde intermédiaire et pour cet exemple se trouve

la suivante :

$$\alpha_2 = 0.790145 \rightarrow \begin{array}{l} a_2 = 2.723001\,m \\ b_2 = 2.697270\,m \end{array}$$

$$\frac{\kappa_2}{\kappa_1} = -0.259402$$

$$\frac{\kappa_3}{\kappa_1} = 0.108687$$

$$B_0 = 0.811169\,\mu_0\kappa_1$$

$$Q = 0.135029$$

Selon l'invention, après avoir déterminé la configuration souhaitée avec deux ou trois solénoïdes minces comme indiqué précédemment, on remplace les nappes de courant superficielles coaxiales successives par des bobinages hélicoïdaux supraconducteurs axisymétriques à demi-section axiale rectangulaire d'épaisseur non nulle 1, 2 ou 101, 102, 103 tels que les extrémités latérales extérieures des bobinages hélicoïdaux 1, 2 ou 101, 102, 103 soient disposées au voisinage d'une même sphère 5 ou 105 de rayon c dont le centre O est placé sur l'axe Oz au centre de la zone d'intérêt ZI et qui englobe l'ensemble du dispositif d'aimant.

On obtient ainsi un dispositif d'aimant circumsphérique réel avec des bobines d'épaisseur prédéterminée. Le passage des solutions idéales précédentes déterminées lors d'une première étape à des configurations réelles est alors à ce stade très simple. Il suffit de remplacer les solénoïdes minces par des bobinages à demi-section axiale rectangulaire dont l'épaisseur est maintenant finie.

On retrouve ici un problème d'optimisation classique dans lequel on fixe des paramètres géométriques (rayon intérieur de bobinage $a_{11}$, rayon extérieur maximum $a_{32}$, longueur totale maximum $2b_1$) et les densités de courant hors tout pour les bobines, avec ou sans gradation. Les données géométriques obtenues pour les configurations idéales à même nombre de bobines fournissent les valeurs de départ nécessaires, en particulier les épaisseurs $e_i$ des bobinages réels à densité de courant $j_i$ avec $j_i e_i \approx \kappa_i$.

On a tracé en pointillé sur les Figures 1 et 2 la trace de la plus petite sphère 5 respectivement 105 ainsi que celle (carrée) du plus petit cylindre 6 respectivement 106 englobant l'aimant.

Selon l'invention, on part d'un ensemble de solénoïdes minces, afin de pouvoir résoudre simultanément et de façon automatique le problème de l'homogénéité et de la réduction du champ de fuite, la condition imposée étant alors simple et résidant dans la nécessité que les cercles d'extrémité des solénoïdes minces soient situés sensiblement sur la même sphère. Un solénoïde mince étant un idéal théorique alors que dans un bobinage réel, il faut bien une certaine épaisseur pour faire passer le courant, même dans un supraconducteur, selon l'invention, on fait évoluer la solution obtenue avec des solénoïdes minces en les rendant plus épais, par un processus d'optimisation comme indiqué plus haut. Dans ces conditions, aucun des cercles d'extrémité des solénoïdes épais (celui du rayon intérieur et celui du rayon extérieur) ne peut plus se trouver rigoureusement sur la même sphère, mais ces cercles d'extrémité restent au voisinage d'une sphère correspondant au cas idéal avec solénoïdes minces, le voisinage des cercles d'extrémité par rapport à la sphère étant d'autant plus proche que les solénoïdes sont moins épais. Par contre, malgré ce voisinage moins proche, on peut conserver pour l'ensemble de solénoïdes épais réels, les mêmes propriétés d'homogénéité et de champ de fuite que celles que l'on avait pour l'ensemble de solénoïdes minces, en choisissant convenablement les rayons intérieur et extérieur (qui encadrent le rayon du solénoïde mince correspondant) et les longueurs (chacune étant également voisine de celle du solénoïde mince correspondant), le tout restant globalement inscrit approximativement dans une sphère.

En résumé, Le dispositif d'aimant supraconducteur compact pour générer une composante de champ magnétique intense et homogène Bz selon un axe Oz dans une zone d'intérêt ZI, comprend successivement en partant de l'axe Oz, au moins deux bobinages 1, 2 hélicoïdaux supraconducteurs coaxiaux réalisés autour de tranches de cylindre circulaire 10, 20 d'axe Oz délimitées par des cercles d'extrémité 10A, 10B, 20A, 20B. Les extrémités latérales des bobinages hélicoïdaux 1, 2 (ou 101 à 103) sont disposées, à l'épaisseur des bobinages près, au voisinage d'une même sphère 5 (ou 105) de rayon c dont le centre O est placé sur l'axe Oz au centre de la zone d'intérêt ZI et qui englobe l'ensemble du dispositif d'aimant. Les densités de courant azimutales $j_1$, $j_2$ des bobinages hélicoïdaux 1, 2 (ou les densités de courant azimutales $j_1$, $j_2$, $j_3$ des bobinages hélicoïdaux 101 à 103) présentent alternativement des signes opposés. Les longueurs $2b_1$, $2b_2$ (et le cas échéant $2b_3$) des bobinages hélicoïdaux 1, 2 (ou 101 à 103) sont décroissantes. Des anneaux 4 ; 104 en matériau magnétique centrés sur l'axe Oz et présentant une symétrie par rapport à un plan médian xOy passant par le centre O de la sphère 5 ; 105 et perpendiculaire à l'axe Oz sont interposés entre les premier et deuxièmes bobinages 1, 2 ; 101, 102 à l'intérieur de la sphère 5 ; 105 et sont aimantés à saturation avec une aimantation en sens inverse de celle du champ créé au centre O de la sphère 5 ; 105.

Selon un mode particulier de réalisation, le rayon extérieur $a_{22}$ (ou $a_{32}$) du bobinage hélicoïdal supraconducteur le plus extérieur 2 (ou 103) est sensiblement égal à la demi-longueur $b_1$ du bobinage hélicoïdal supraconducteur le plus intérieur 1 (ou 101) et le rayon extérieur $a_{12}$ du bobinage hélicoïdal supraconducteur le plus intérieur 1 (ou 101) est sensiblement égal à la demi-longueur $b_2$ (ou $b_3$) du bobinage hélicoïdal supraconducteur le plus extérieur 2 (ou 103).

## Revendications

**1.** Dispositif d'aimant supraconducteur compact pour générer une composante de champ magnétique homogène Bz selon un axe Oz dans une zone d'intérêt ZI pour des applications de résonance magnétique nucléaire ou d'imagerie par résonance magnétique, comprenant successivement en partant de l'axe Oz et dans une direction perpendiculaire à cet axe Oz, un premier bobinage (1 ; 101) hélicoïdal supraconducteur réalisé autour d'une première tranche de cylindre circulaire (10 ; 110) d'axe Oz délimitée par des premiers cercles d'extrémité (10A, 10B ; 110A, 110B), ledit premier bobinage (1 ; 101) hélicoïdal supraconducteur présentant un premier rayon extérieur ($a_{12}$), un premier rayon intérieur ($a_{11}$), et une première longueur ($2b_1$), avec une première densité de courant azimutale $j_1$, au moins un deuxième bobinage (2 ; 102) hélicoïdal supraconducteur réalisé autour d'une deuxième tranche de cylindre circulaire (20 ; 120) d'axe Oz délimitée par des deuxièmes cercles d'extrémité (20A, 20B ; 120A, 120B) et entourant ladite première tranche de cylindre circulaire (10 ; 110), ledit deuxième bobinage (2 ; 102) présentant un deuxième rayon extérieur ($a_{22}$), un deuxième rayon intérieur ($a_{21}$), et une deuxième longueur ($2b_2$), avec une deuxième densité de courant azimutale $j_2$, **caractérisé en ce que** les extrémités latérales des premier et deuxième bobinages hélicoïdaux (1, 2 ; 101, 102) sont disposées, à l'épaisseur des bobinages près, au voisinage d'une même sphère (5 ; 105) de rayon c dont le centre O est placé sur l'axe Oz au centre de ladite zone d'intérêt ZI et qui englobe l'ensemble du dispositif d'aimant, **en ce que** les première et deuxième densités de courant azimutales $j_1$, $j_2$ présentent des signes opposés, et **en ce que** des anneaux (4 ; 104) en matériau magnétique centrés sur l'axe Oz et présentant une symétrie par rapport à un plan médian xOy passant par le centre O de la sphère (5 ; 105) et perpendiculaire à l'axe Oz sont interposés entre les premier et deuxièmes bobinages (1, 2 ; 101, 102) à l'intérieur de ladite sphère (5 ; 105) et sont aimantés à saturation avec une aimantation en sens inverse de celle du champ créé au centre O de ladite sphère (5 ; 105).

**2.** Dispositif d'aimant selon la revendication 1, **caractérisé en ce qu'**il comprend en outre au moins un troisième bobinage (103) hélicoïdal supraconducteur réalisé autour d'une troisième tranche de cylindre circulaire (130) d'axe Oz délimitée par des troisièmes cercles d'extrémité (130A, 130B) et entourant ladite deuxième tranche de cylindre circulaire (120), ledit troisième bobinage (103) présentant un troisième rayon extérieur ($a_{32}$), un troisième rayon intérieur ($a_{31}$), et une troisième longueur ($2b_3$), avec une troisième densité de courant azimutale $j_3$, **en ce que** les première, deuxième et troisième densités de courant azimutales $j_1$, $j_2$, $j_3$ présentent des signes alternativement opposés, et **en ce que** les première, deuxième et troisième longueurs ($2b_1$, $2b_2$, $2b_3$) des premier, deuxième et troisième bobinages (101, 102, 103) sont décroissantes.

**3.** Dispositif d'aimant supraconducteur selon la revendication 1 ou la revendication 2, **caractérisé en ce que** les anneaux (4 ; 104) en matériau magnétique centrés sur l'axe Oz comprennent deux paires d'anneaux de sections différentes (41,44 et 42, 43 ; 141, 144 et 142, 143) disposés symétriquement par rapport audit plan médian xOy.

**4.** Dispositif selon l'une quelconque des revendications 1 à 3, **caractérisé en ce que** les anneaux (4 ; 104) en matériau magnétique sont en matériau magnétique ayant une aimantation à saturation au moins aussi élevée que celle du fer.

**5.** Dispositif selon la revendication 4, **caractérisé en ce que** les anneaux (4 ; 104) en matériau magnétique sont en fer ou en alliage de fer.

**6.** Dispositif selon la revendication 5, **caractérisé en ce que** les anneaux (4 ; 104) en matériau magnétique sont en alliage de fer et de cobalt.

**7.** Dispositif selon l'une quelconque des revendications 1 à 3, **caractérisé en ce que** les anneaux (4 ; 104) en matériau magnétique sont en ferrite de composition $XFe_2O_4$, où X est constitué par un ou plusieurs des éléments comprenant Mn, Zn, Ni, Co, Cu, Mg, Fe.

**8.** Procédé de réalisation d'un dispositif d'aimant supraconducteur pour générer une composante de champ magnétique homogène Bz selon un axe Oz dans une zone d'intérêt (10 ; 110) pour des applications de résonance magnétique nucléaire ou d'imagerie par résonance magnétique, **caractérisé en ce qu'**il comprend les étapes suivantes :

a. déterminer une première tranche de cylindre circulaire (10 ; 110) d'axe Oz délimitée par des premiers cercles d'extrémité (10A, 10B ; 110A, 110B) et présentant un premier rayon prédéfini ($a_1$) et une première longueur prédéfinie ($2b_1$) correspondant respectivement au rayon minimum et à la longueur maximum de ladite zone d'intérêt ZI,

b. déterminer une dernière tranche de cylindre circulaire (20 ; 130) d'axe Oz délimitée par des derniers cercles d'extrémité (20A, 20B ; 130A, 130B), entourant ladite première tranche de cylindre circulaire (10 ; 110) et présentant un dernier rayon prédéfini ($a_2$ ; $a_3$) et une dernière longueur prédéfinie ($2b_2$ ; $2b_3$) de telle sorte que ladite dernière tranche de cylindre circulaire (20 ; 130) soit contenue dans une sphère de rayon c et de centre O contenant ladite zone d'intérêt ZI,

c. considérer une première nappe de courant superficielle formée sur la première tranche de cylindre circulaire (10 ; 110) d'axe Oz, et une dernière nappe de courant superficielle mince formée sur la dernière tranche de cylindre circulaire (20 ; 130) d'axe Oz, les nappes de courant superficielles successives coaxiales présentant chacune une densité superficielle de courant azimutale $\kappa_i$ telle que deux nappes de courant superficielles coaxiales adjacentes présentent des densités superficielles de courant azimutales de signes opposés et déterminer la géométrie d'anneaux (4 ; 104) en matériau magnétique intermédiaires centrés sur l'axe Oz et présentant une symétrie par rapport à un plan médian xOy passant par le centre O de la sphère (5 ; 105) et perpendiculaire à l'axe Oz et interposés entre les premier et deuxièmes bobinages (1, 2 ; 101, 102) à l'intérieur de ladite sphère (5 ; 105), lesdits anneaux (4 ; 104) étant aimantés avec une aimantation en sens inverse de celle du champ créé au centre O de ladite sphère (5 ; 105) de manière à optimiser l'homogénéité du champ magnétique dans ladite zone d'intérêt ZI, et

d. remplacer les nappes de courant superficielles coaxiales successives par des bobinages hélicoïdaux supraconducteurs axisymétriques à demi-section axiale rectangulaire d'épaisseur non nulle (1, 2 ; 101, 102, 103) tels que les extrémités latérales des bobinages hélicoïdaux (1, 2 ; 101, 102, 103) soient disposées, à l'épaisseur des bobinages près, au voisinage d'une même sphère (5 ; 105) de rayon c dont le centre O est placé sur l'axe Oz au centre de ladite zone d'intérêt (ZI) et qui englobe l'ensemble du dispositif d'aimant.

**9.** Procédé selon la revendication 8, **caractérisé en ce que** l'on détermine en outre une tranche de cylindre circulaire intermédiaire (120) d'axe Oz délimitée par des cercles d'extrémité intermédiaires (120A, 120B), intercalée entre ladite première tranche de cylindre circulaire (110) et ladite dernière tranche de cylindre circulaire (130), ladite tranche de cylindre circulaire intermédiaire (120) présentant un rayon prédéfini intermédiaire ($a_2$) compris entre le rayon minimum ($a_1$) de ladite zone d'intérêt Z et le dernier rayon prédéfini ($a_3$) et une longueur prédéfinie intermédiaire ($2b_2$) comprise entre ladite dernière longueur prédéfinie ($2b_3$) et ladite longueur maximum ($2b_1$), de telle sorte que les premiers cercles d'extrémité (110A, 110B), les cercles d'extrémité intermédiaires (120A, 120B) et les derniers cercles d'extrémité (130A, 130B) soient situés sensiblement sur ladite sphère (105) de centre O et de rayon c, on détermine une nappe de courant superficielle intermédiaire et on détermine un bobinage hélicoïdal supraconducteur axisymétrique intermédiaire (102) à demi-section axiale rectangulaire d'épaisseur non nulle, les anneaux (104) en matériau magnétique étant disposés dans l'espace libre situé entre le premier bobinage hélicoïdal supraconducteur (101) correspondant à la première tranche de cylindre circulaire (110) et le bobinage hélicoïdal supraconducteur axisymétrique intermédiaire (102) correspondant à la tranche de cylindre circulaire intermédiaire (120).

**10.** Procédé selon la revendication 8 ou la revendication 9, **caractérisé en ce que** les anneaux (4 ; 104) en matériau magnétique sont choisis en matériau magnétique ayant une aimantation à saturation au moins aussi élevée que celle du fer.

**11.** Procédé selon la revendication 10, **caractérisé en ce que** les anneaux (4 ; 104) en matériau magnétique sont choisis en fer ou en alliage de fer.

**12.** Procédé selon la revendication 11, **caractérisé en ce que** les anneaux (4 ; 104) en matériau magnétique sont choisis en alliage de fer et de cobalt.

13. Procédé selon la revendication 8 ou la revendication 9, **caractérisé en ce que** les anneaux (4 ; 104) en matériau magnétique sont choisis en ferrite de composition $XFe_2O_4$, où X est constitué par un ou plusieurs des éléments comprenant Mn, Zn, Ni, Co, Cu, Mg, Fe.

**Patentansprüche**

1. Kompakte supraleitende Magnetvorrichtung, um eine homogene Magnetfeldkomponente Bz entlang einer Achse Oz in einer Interessenszone ZI für Anwendungen von nuklearer Magnetresonanz oder Bildgebung durch Magnetresonanz zu erzeugen, umfassend nacheinander ausgehend von der Achse Oz und in eine Richtung senkrecht zu dieser Achse Oz eine erste supraleitende Spiralwicklung (1; 101), die um einen ersten kreisförmigen Zylinderabschnitt (10; 110) mit der Achse Oz, der durch erste Endkreise (10A, 10B; 110A, 110B) begrenzt ist, ausgeführt ist, wobei die erste supraleitende Spiralwicklung (1; 101) einen ersten Außenradius ($a_{12}$), einen ersten Innenradius ($a_{11}$), und eine erste Länge ($2b_1$) mit einer ersten azimutalen Stromdichte $j_1$ aufweist, mindestens eine zweite supraleitende Spiralwicklung (2; 102), die um einen zweiten kreisförmigen Zylinderabschnitt (20; 120) mit der Achse Oz, der durch zweite Endkreise (20A, 20B; 120A, 120B) begrenzt ist und den ersten kreisförmigen Zylinderabschnitt (10; 110) umgibt, ausgeführt ist, wobei die zweite Wicklung (2; 102) eine zweiten Außenradius ($a_{22}$), einen zweiten Innenradius ($a_{21}$) und eine zweite Länge ($2b_2$) mit einer zweiten azimutalen Stromdichte $j_2$ aufweist, **dadurch gekennzeichnet, dass** die seitlichen Enden der ersten und zweiten Spiralwicklungen (1, 2; 101, 102) bis auf die Dicke der Wicklungen in der Nähe einer selben Kugel (5; 105) mit dem Radius c angeordnet sind, deren Mittelpunkt O auf der Achse Oz in der Mitte der Interessenszone ZI angeordnet ist, und die die Gesamtheit der Magnetvorrichtung umgibt, dass die ersten und zweiten azimutalen Stromdichten $j_1$, $j_2$ entgegengesetzte Vorzeichen aufweisen, und dass Ringe (4; 104) aus magnetischem Material, die auf der Achse Oz zentriert sind und eine Symmetrie in Bezug zu einer Mittelebene xOy aufweisen, die durch den Mittelpunkt O der Kugel (5; 105) verläuft und auf die Achse Oz senkrecht ist, zwischen den ersten und zweiten Wicklungen (1, 2; 101, 102) im Inneren der Kugel (5; 105) angeordnet und mit einer Sättigung magnetisiert sind, mit einer Magnetisierung in umgekehrte Richtung zu jener des im Mittelpunkt O der Kugel (5; 105) erzeugten Feldes.

2. Magnetvorrichtung nach Anspruch 1, **dadurch gekennzeichnet, dass** sie ferner mindestens eine dritte supraleitende Spiralwicklung (103) umfasst, die um einen dritten kreisförmigen Zylinderabschnitt (130) mit der Achse Oz, der durch dritte Endkreise (130A, 130B) begrenzt ist und den zweiten kreisförmigen Zylinderabschnitt (120) umgibt, ausgeführt ist, wobei die dritte Wicklung (103) einen dritten Außenradius ($a_{32}$), einen dritten Innenradius ($a_{31}$) und eine dritte Länge ($2b_3$) mit einer dritten azimutalen Stromdichte $j_3$ aufweist, dass die ersten, zweiten und dritten azimutalen Stromdichten $j_1$, $j_2$, $j_3$ abwechselnd entgegengesetzte Vorzeichen aufweisen, und dass die ersten, zweiten und dritten Längen ($2b_1$, $2b_2$, $2b_3$) der ersten, zweiten und dritten Wicklungen (101, 102, 103) abnehmend sind.

3. Supraleitende Magnetvorrichtung nach Anspruch 1 oder Anspruch 2, **dadurch gekennzeichnet, dass** die Ringe (4; 104) aus magnetischem Material, die auf der Achse Oz zentriert sind, zwei Ringpaare mit unterschiedlichen Querschnitten (41, 44 und 42, 43; 141, 144 und 142, 143) umfassen, die symmetrisch zur Mittelebene xOy angeordnet sind.

4. Vorrichtung nach einem der Ansprüche 1 bis 3, **dadurch gekennzeichnet, dass** die Ringe (4; 104) aus magnetischem Material aus einem magnetischen Material mit einer Magnetisierung, die mindestens ebenso hoch Sättigung wie jene des Eisens ist, sind.

5. Vorrichtung nach Anspruch 4, **dadurch gekennzeichnet, dass** die Ringe (4; 104) aus magnetischem Material aus Eisen oder einer Eisenlegierung sind.

6. Vorrichtung nach Anspruch 5, **dadurch gekennzeichnet, dass** die Ringe (4; 104) aus magnetischem Material aus einer Eisenlegierung oder Kobalt sind.

7. Vorrichtung nach einem der Ansprüche 1 bis 3, **dadurch gekennzeichnet, dass** die Ringe (4; 104) aus magnetischem Material aus Ferrit mit der Zusammensetzung $XFe_2O_4$ sind, wobei X von einem oder mehreren Elementen, umfassend Mn, Zn, Ni, Co, Cu, Mg, Fe, gebildet ist.

8. Verfahren zur Herstellung einer supraleitenden Magnetvorrichtung, um eine homogene Magnetfeldkomponente Bz entlang einer Achse Oz in einer Interessenszone (10; 110) für Anwendungen von nuklearer Magnetresonanz oder Bildgebung durch Magnetresonanz zu erzeugen, **dadurch gekennzeichnet, dass** es die folgenden Schritte umfasst:

a. Bestimmung eines ersten kreisförmigen Zylinderabschnitts (10; 110) mit der Achse Oz, der durch erste Endkreise (10A, 10B; 110A, 110B) begrenzt ist und einen ersten vordefinierten Radius ($a_1$) und eine erste vordefinierte Länge ($2b_1$), die dem Mindestradius bzw. der Maximallänge der Interessenzone ZI entsprechen, aufweist,

b. Bestimmung eines letzten kreisförmigen Zylinderabschnitts (20; 130) mit der Achse Oz, der durch letzte Endkreise (20A, 20B; 130A, 130B) begrenzt ist, den ersten kreisförmigen Zylinderabschnitt (10; 110) umgibt und einen letzten vordefinierten Radius ($a_2$, $a_3$) und eine letzte vordefinierte Länge ($2b_2$; $2b_3$) aufweist, so dass der letzte kreisförmige Zylinderabschnitt (20; 130) in einer Kugel mit einem Radius c und einem Mittelpunkt O enthalten ist, die die Interessenszone ZI enthält,

c. Vorsehen einer ersten oberflächlichen Stromschicht, die auf dem ersten kreisförmigen Zylinderabschnitt (10; 110) mit der Achse Oz ausgebildet ist, und einer letzten dünnen oberflächlichen Stromschicht, die auf dem letzten kreisförmigen Zylinderabschnitt (20; 130) mit der Achse Oz ausgebildet ist, wobei die koaxialen aufeinanderfolgenden oberflächlichen Stromschichten jeweils eine azimutale oberflächliche Stromdichte $k_i$ aufweisen, so dass zwei aneinandergrenzende koaxiale oberflächliche Stromschichten azimutale oberflächliche Stromdichten mit entgegengesetzten Vorzeichen aufweisen, und Bestimmung der Geometrie von Zwischenringen (4; 104) aus magnetischem Material, die auf der Achse Oz zentriert sind und eine Symmetrie in Bezug zu einer Mittelebene xOy aufweisen, die durch den Mittelpunkt O der Kugel (5; 105) verläuft und auf die Achse Oz senkrecht ist, und die zwischen den ersten und zweiten Wicklungen (1, 2; 101, 102) im Inneren der Kugel (5; 105) angeordnet sind, wobei die Ringe (4; 104) mit einer Magnetisierung in umgekehrte Richtung zu jener des Feldes, das im Mittelpunkt O der Kugel (5; 105) erzeugt wird, magnetisiert sind, um die Homogenität des Magnetfeldes in der Interessenszone ZI zu optimieren, und

d. Ersetzen der aufeinanderfolgenden koaxialen oberflächlichen Stromschichten durch achssymmetrische supraleitende Spiralwicklungen mit einem rechteckigen halben Axialquerschnitt mit einer Dicke ungleich Null (1, 2; 101, 102, 103), so dass die seitlichen Enden der Spiralwicklungen (1, 2; 101, 102, 103) bis auf die Dicke der Wicklungen in der Nähe einer selben Kugel (5; 105) mit einem Radius c angeordnet sind, deren Mittelpunkt O auf der Achse Oz in der Mitte der Interessenszone (ZI) angeordnet ist, und die die Gesamtheit der Magnetvorrichtung umgibt.

9. Verfahren nach Anspruch 8, **dadurch gekennzeichnet, dass** ferner ein kreisförmiger Zwischenzylinderabschnitt (120) mit der Achse Oz bestimmt wird, der von Zwischenendkreisen (120A, 120B) begrenzt ist, die zwischen dem ersten kreisförmigen Zylinderabschnitt (110) und dem letzten kreisförmigen Zylinderabschnitt (130) angeordnet sind, wobei der kreisförmige Zwischenzylinderabschnitt (120) einen vordefinierten Zwischenradius ($a_2$), der zwischen dem Mindestradius ($a_1$) der Interessenszone Z und dem letzten vordefinierten Radius ($a_3$) enthalten ist, und eine vordefinierte Zwischenlänge ($2b_2$) aufweist, die zwischen der letzten vordefinierten Länge ($2b_3$) und der Maximallänge ($2b_1$) enthalten ist, so dass die ersten Endkreise (110A, 110B), die Zwischenendkreise (120A, 120B) und die letzten Endkreise (130A, 130B) im Wesentlichen auf der Kugel (105) mit dem Mittelpunkt O und einem Radius c angeordnet sind, eine oberflächliche Stromzwischensicht bestimmt wird und eine achssymmetrische supraleitende Zwischenspiralwicklung (102) mit einem rechteckigen halben Axialquerschnitt mit einer Dicke ungleich Null bestimmt wird, wobei die Ringe (104) aus magnetischem Material in dem Freiraum angeordnet sind, der sich zwischen der ersten supraleitenden Spiralwicklung (101) entsprechend dem ersten kreisförmigen Zylinderabschnitt (110) und der achssymmetrischen supraleitenden Zwischenspiralwicklung (102), entsprechend dem kreisförmigen Zwischenzylinderabschnitt (120) befindet.

10. Verfahren nach Anspruch 8 oder Anspruch 9, **dadurch gekennzeichnet, dass** die Ringe (4; 104) aus magnetischem Material aus einem magnetischen Material ausgewählt sind, das eine Magnetisierung mit einer Sättigung, die mindestens gleich hoch wie jene des Eisens ist, aufweist.

11. Verfahren nach Anspruch 10, **dadurch gekennzeichnet, dass** die Ringe (4; 104) aus magnetischem Material aus Eisen oder einer Eisenlegierung ausgewählt sind.

12. Verfahren nach Anspruch 11, **dadurch gekennzeichnet, dass** die Ringe (4; 104) aus magnetischem Material aus einer Eisenlegierung und Kobalt ausgewählt sind.

13. Verfahren nach Anspruch 8 oder Anspruch 9, **dadurch gekennzeichnet, dass** die Ringe (4; 104) aus magnetischem Material aus Ferrit mit der Zusammensetzung $XFe_2O_4$ ausgewählt sind, wobei X von einem oder mehreren der Elemente, umfassend Mn, Zn, Ni, Co, Cu, Mg, Fe, gebildet ist.

**Claims**

1. A compact superconducting magnet device to generate a homogeneous magnetic field component Bz along an axis Oz in a zone of interest ZI for nuclear magnetic resonance or magnetic resonance imaging applications, successively comprising, starting from the axis Oz and in a direction perpendicular to this axis Oz, a first superconducting helical coil (1; 101) around a first circular cylinder section (10; 110) of axis Oz delimited by first end circles (10A, 10B ; 110A, 110B), said first superconducting helical coil (1; 101) having a first outer radius ($a_{12}$), a first inner radius ($a_{11}$), and a first length ($2b_1$), with a first azimuthal current density $j_1$, at least one second superconducting helical coil (2; 102) formed around a second circular cylinder section (20; 120) of axis Oz delimited by second end circles (20A, 20B; 120A, 120B) and surrounding said first circular cylinder section (10; 110), the said second coil (2; 102) having a second outer radius ($a_{22}$), a second inner radius ($a_{21}$) and a second length ($2b_2$), with a second azimuthal current density $j_2$, **characterized in that** the lateral ends of the first and second helical coils (1, 2; 101, 102) are arranged, to within the thickness of the coils, in the vicinity of one same sphere (5; 105) of radius c whose centre O is placed on the axis Oz in the centre of said zone of interest ZI and which encompasses the magnet device assembly, **in that** the first and second azimuthal current densities $j_1$, $j_2$ are of opposite sign, and **in that** rings (4; 104) in magnetic material centred on the axis Oz and having symmetry relative to a median plane xOy passing through the centre O of the sphere (5; 105) perpendicular to the axis Oz are inserted between the first and second coils (1, 2; 101, 102) inside said sphere (5 ; 105) and are magnetized to saturation with magnetization in opposite direction to that of the field set up in the centre O of said sphere (5; 105).

2. The magnet device according to claim 1, **characterized in that** it further comprises at least one third superconducting helical coil (103) formed around a third circular cylinder section (130) of axis Oz delimited by third end circles (130A, 130B) and surrounding said second circular cylinder section (120), said third coil (103) having a third outer radius ($a_{32}$), a third inner radius ($a_{31}$) and a third length ($2b_3$), with a third azimuthal current density $j_3$, **in that** the first, second and third azimuthal current densities $j_1$, $j_2$, $j_3$ are alternately of opposite sign, and **in that** the first, second and third lengths ($2b_1$, $2b_2$, $2b_3$) of the first, second and third coils (101, 102, 103) are of decreasing lengths.

3. The superconducting magnet device according to claim 1 or claim 2, **characterized in that** the rings (4; 104) in magnetic material centred on the axis Oz comprise two pairs of rings of different cross-sections (41,44 and 42, 43; 141, 144 and 142, 143) arranged symmetrically relative to the said median plane xOy.

4. The device according to any of claims 1 to 3, **characterized in that** the rings (4; 104) in magnetic material are in magnet material having saturation magnetization at least as high as that of iron.

5. The device according to claim 4 **characterized in that** the rings (4; 104) in magnetic material are in iron or an iron alloy.

6. The device according to claim 5 **characterized in that** the rings (4; 104) in magnetic material are in an alloy of iron and cobalt.

7. The device according to any of claims 1 to 3, **characterized in that** the rings (4; 104) in magnetic material are in ferrite of composition $XFe_2O_4$, where X is formed of one or more of the elements comprising Mn, Zn, Ni, Co, Cu, Mg, Fe.

8. A method for producing a superconducting magnet device to generate a homogeneous magnetic field component Bz along an axis Oz in a zone of interest (10; 110) for nuclear magnetic resonance or magnetic resonance imaging applications, **characterized in that** it comprises the following steps:

   a. determining a first circular cylinder section (10; 110) of axis Oz delimited by first end circles (10A, 10B; 110A, 110B) and having a first predefined radius ($a_1$) and a first predefined length ($2b_1$) respectively corresponding to the minimum radius and the maximum length of said zone of interest ZI,
   b. determining a last circular cylinder section (20; 130) of axis Oz delimited by last end circles (20A, 20B; 130A, 130B), surrounding said first circular cylinder section (10; 110) and having a last predefined radius ($a_2$; $a_3$) and a last predefined length ($2b_2$; $2b_3$) so that said last circular cylinder section (20; 130) is contained within a sphere of radius c and centre O containing said zone of interest ZI,
   c. considering a first surface current sheet formed on the first circular cylinder section (10; 110) of axis Oz, and a last thin surface current sheet formed on the last circular cylinder section (20; 130) of axis Oz, the successive coaxial surface current sheets each having a surface azimuthal current density $\kappa_i$ such that two adjacent coaxial surface current sheets have surface azimuthal current densities of opposite sign, and determining the geometry of intermediate rings (4; 104) in magnetic material centred on the axis Oz and having symmetry relative to a median plane xOy passing through the centre O of the sphere (5; 105) and perpendicular to the axis Oz and inserted between the first and second coils (1, 2; 101, 102) inside said sphere (5; 105), the said rings (4; 104) being magnetized with magnetization in opposite direction to that of the field set up at the centre O of said sphere (5; 105) so as to optimize the homogeneity of the magnetic field in said zone of interest ZI, and

d. replacing the successive coaxial surface current sheets by axisymmetric superconducting coils with rectangular axial half-section of nonzero thickness (1, 2; 101, 102, 103) such that the lateral ends of the helical coils (1, 2 ; 101, 102, 103) are arranged, to within the thickness of the coils, in the vicinity of one same sphere (5; 105) of radius c whose centre O is placed on the axis Oz at the centre of said zone of interest (ZI) and which encompasses the magnet device assembly.

**9.** The method according to claim 8, **characterized in that** an intermediate circular cylinder section (120) is also determined of axis Oz delimited by intermediate end circles (120A, 120B), inserted between said first circular cylinder section (110) and said last circular cylinder section (130), said intermediate circular cylinder section (120) having an intermediate predefined radius ($a_2$) of between the minimum radius ($a_1$) of said zone of interest ZI and the last predefined radius ($a_3$) and an intermediate predefined length ($2b_2$) of between said last predefined length ($2b_3$) and said maximum length ($2b_1$), so that the first end circles (110A, 110B), the intermediate end circles (120A, 120B) and the last end circles (130A, 130B) are positioned substantially on said sphere (105) of centre O and radius c, an intermediate surface current sheet is determined and an intermediate axisymmetric superconducting helical coil is determined with rectangular axial half-section of nonzero thickness, the rings (104) in magnetic material being arranged in the free space contained between the first superconducting helical coil (101) corresponding to the first circular cylinder section (110) and the intermediate axisymmetric superconducting helical coil (102) corresponding to the intermediate circular cylinder section (120).

**10.** The method according to claim 8 or claim 9, **characterized in that** the rings (4; 104) in magnetic material are chosen from magnetic material having saturation magnetization at least as high as that of iron.

**11.** The method according to claim 10, **characterized in that** the rings (4; 104) in magnetic material are chosen from iron or an iron alloy.

**12.** The method according to claim 11, **characterized in that** the rings (4; 104) in magnetic material are chosen to be an iron and cobalt alloy.

**13.** The method according to claim 8 or claim 9, **characterized in that** the rings (4; 104) in magnetic material are chosen from a ferrite of composition $XFe_2O_4$, where X is formed by one or more of the elements comprising Mn, Zn, Ni, Co, Cu, Mg, Fe.

**FIG.1**

**FIG.2**

**EP 2 593 805 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20090261246 A1